# EUROPÄISCHE PATENTANMELDUNG

(11) **EP 2 075 841 A2**
(43) Veröffentlichungstag der Anmeldung: **01.07.2009**
(21) Anmeldenummer: 08105665.7
(22) Anmeldetag: 27.10.2008
(51) Int. Cl.: H01L 27/146, H01L 27/30

(54) **Bildaufnehmer, sowie Herstellungsverfahren und Verwendung davon**

(30) Priorität: 27.12.2007 DE 102007062708
(71) Anmelder: Robert Bosch GmbH, 70442 Stuttgart (DE)
(72) Erfinder: Niem, Wolfgang, 31141 Hildesheim (DE); Niehsen, Wolfgang, 31162 Bad Salzdetfurth (DE); Wingbermuehle, Jochen, 30966 Hemmingen (DE)

(57) **Zusammenfassung**

Bei einem Bildaufnehmer (1), bestehend aus einer Array-Struktur, wobei pro Pixel ein Fotosensor (2) mit einer Mikrolinse (3) ausgestattet ist, wird die Array-Struktur formstabil gewölbt ausgebildet zur Anpassung an gewölbte Oberflächen oder permanent flexibel ausgebildet.

## Beschreibung

### Stand der Technik

Die Erfindung geht aus von einem Bildaufnehmer gemäß dem Oberbegriff des Patentanspruchs 1. Gegenstand der Erfindung ist auch ein Verfahren zur Herstellung eines solchen Bildaufnehmers wie auch eine Verwendung.

Systeme zur digitalen Bildauswertung gewinnen bereits heute in vielen Anwendungsbereichen, etwa für Überwachungssysteme, für Assistenzfunktionen im Kraftfahrzeug oder in der Robotik zunehmend an Bedeutung. Die Flexibilität dieser sehenden Systeme lässt den Einsatz in vielen weiteren Bereichen zu.

Grundlegende Komponenten eines solchen sehenden Systems sind ein Bildsensor und eine Auswerteeinheit. Das vom Sensor aufgenommene Bildsignal wird zur Auswerteeinheit übertragen und dort verarbeitet. Die Übertragung kann dabei über Leitungen oder auch per Funkstrecke erfolgen, wodurch Position und Gestaltung der Auswerteeinheit relativ frei gewählt werden kann. Der Bildsensor selbst muss demgegenüber stets so verbaut werden, dass er den relevanten Raumbereich erfasst. In vielen Fällen ist trotzdem eine einfache unauffällige Integration der Sensorik wünschenswert, so sollen z.B. eine Überwachungskamera oder eine Kamera im Fahrzeug in der Regel nicht unmittelbar ins Auge fallen.

Herkömmliche Kameras arbeiten nach dem Prinzip einer Lochkamera, sie bestehen aus einem lichtempfindlichen flächigen Bildaufnehmer, der durch eine Linsenoptik (Objektiv) mit Blende belichtet wird. Diese Bauform bedingt eine relativ große Bautiefe, welche der einfachen Integration in vielen Anwendungsfällen entgegensteht. Vor diesem Hintergrund wird, auch getrieben durch den aktuellen Trend zur Integration von Kameras in Mobiltelefonen, verstärkt an einer kostengünstigen Miniaturisierung herkömmlicher Kameras gearbeitet. Eines der Hauptprobleme der Miniaturisierung ist hier die mit verkleinerter Optik geringer werdende Lichtmenge, die für die Belichtung eines Pixels des Bildaufnehmers zur Verfügung steht, wodurch letztlich ein verschlechtertes Signal-/Rauschverhältnis in Kauf genommen werden muss.

Parallel zur Weiterentwicklung herkömmlicher Kameras bestehen in der Forschung vor allem im Bereich der Robotik neue Ansätze zur Entwicklung ultraflacher planarer Kameras, bei denen jedes Pixel des Bildaufnehmers, ähnlich dem Prinzip eines Facettenauges, mit einer eigenen Mikrolinsenoptik ausgestattet ist. Das gemeinsame Objektiv und insbesondere die hierfür notwendige Bautiefe entfallen. Darüber hinaus wird das Problem des durch eine Miniaturisierung herkömmlicher Kameras verschlechterten Signal-/Rauschverhältnisses umgangen.

Die US 7,205,526 B2 zeigt einen Bildaufnehmer in Array-Struktur mit einem Fotosensor pro Pixel und darüber angeordneter Mikrolinse.

### Offenbarung der Erfindung

### Vorteile der Erfindung

Mit den Maßnahmen des Anspruchs 1 oder des Anspruchs 11 können neue Anwendungsfelder eines solchen Bildaufnehmers erschlossen werden. Zum einen können ultraflache, folienartige Kameras geschaffen werden, die eine einfache und/oder unauffällige Montage/Verbauung der optischen Sensorik gestatten. Der Bildaufnehmer nach der Erfindung kann flexibel oder formstabil mit vorgegebener Wölbung ausgeführt werden.

Gegenüber den bekannten Ansätzen zur Miniaturisierung herkömmlicher Kameras bieten die hier vorgeschlagenen Ausgestaltungen den Vorteil einer geringeren Bautiefe. Gegenüber der Lösung gemäß US 7,205,526 B2 wird durch die optionale Flexibilität und/oder gewölbte Ausführung eine einfachere Verbaubarkeit, insbesondere auf gewölbten Oberflächen, z. B. Karosserien und Textilien, z. B. Kleidung erreicht.

Der Bildaufnehmer gemäß der Erfindung kann in der Kleidung integriert sein und kann zur Unterstützung Sehbehinderter oder zum Schutz von Individuen in Gefahrumgebung wie z. B. Straßenbauarbeitern, Gleisbauarbeitern verwendet werden.

Durch Fusion von bildgebender und weiterer Umfeldsensorik in Verbindung mit einer Auswerteeinrichtung und einer Ausgabeeinheit, insbesondere einem Sprachmodul und/oder einer Bildwiedergabeeinheit, ergibt sich die Nutzung als "künstlicher Blindenhund" oder Fahrerassistent, insbesondere im Zusammenhang mit einem Navigationssystem. Es können Warnhinweise oder Empfehlungen in natürlicher Sprache ausgegeben werden und relevante Umgebungsinformationen in natürlich sprachliche Hinweise, insbesondere für sehbehinderte Personen, umgesetzt werden.

### Zeichnungen

Anhand der Zeichnungen werden Ausführungsformen der Erfindung näher erläutert. Es zeigen:
- Figur 1: einen folienartigen gewölbten Bildaufnehmer mit Auswerteeinheit,
- Figur 2: einen Schnitt durch den Bildaufnehmer mit Fotosensoren auf einer Trägerfolie,
- Figur 3: einen Schnitt durch den Bildaufnehmer mit Fotosensoren, die in eine Trägerfolie integriert sind,
- Figur 4: einen Bildaufnehmer mit Auswerte- und Ausgabeeinheit.

### Ausführungsformen der Erfindung

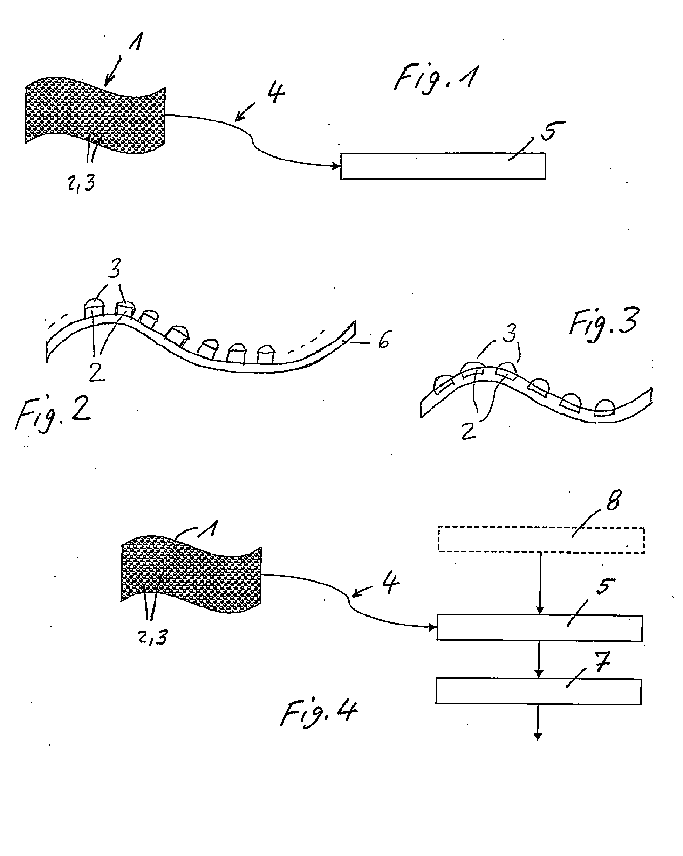

Figur 1 zeigt einen folienartigen gewölbten Bildaufnehmer 1 mit einer Array-Struktur, wobei pro Pixel der Array-Struktur ein Fotosensor 2 mit Mikrolinse 3 ausgestattet ist. Über eine Leitung oder eine Funkstrecke 4 ist dem Bildaufnehmer 1 eine Auswerteeinheit 5 nachgeschaltet. Der Bildaufnehmer 1 kann in sich permanent flexibel oder formstabil mit vorgegebener Wölbung ausgeführt sein.

Figur 2 zeigt einen Schnitt durch den erfindungsgemäßen Bildaufnehmer 1. Die Fotosensoren 2 mit den darüber aufgebrachten Mikrolinsen 3 sind auf einer flexiblen Folie 6 aufgebracht, z. B. durch Verkleben mit dieser. Als flexible Folie 6 eignen sich Polyamide oder Polyimide oder Hybrid-Polymere.

Bei der Ausgestaltung gemäß Figur 3 sind die Fotosensoren 2 in die Folie 6 integriert. Nur die Mikrolinsen 3 ragen über die Folie 6 hinaus. Die Folie 6 besteht hier aus einem gewölbten Substrat, welches formstabil ausgebildet ist.

Es kann auch ein permanent flexibles Substrat, insbesondere aus dem Kunststoff Parylen C vorgesehen sein, in das die Fotosensoren 2 eingebracht werden. Die Fotosensoren 2 können aus einer Fotoresist-Schicht bestehen, die durch bekannte Ätztechniken und Auftragsverfahren (Reflowtechnik) in das Substratmaterial eingebracht wird. Die Fotosensoren 2 können bezüglich ihrer Außenkontur bereits konvex ausgebildet werden und damit schon selbst die Mikrolinse bilden. Es muss dann lediglich eine lichtdurchlässige Schutzschicht, beispielsweise aus Siliziumoxid, aufgebracht werden.

Bei der Verwendung von Parylen C wird dieses als erste Schicht gewählt. Als zweite Schicht eignet sich ORCOMER, einem auf Silikate basierenden anorganisch-organischen Hybrid-Polymer. Darüber wird eine z. B. 55 nm dünne Goldelektrode aufgebraucht sowie zwei organische Halbleiterlagen (Kupfer-Pht.alocyanin Cu-PC, PTCBI, je 40 nm) und zuoberst eine 25 nm dünne Silberelektrode [Phys.stat.sol.(a)202, R50 (2005)].

Figur 4 zeigt einen Bildaufnehmer 1 mit Auswerteeinheit 5 und einer Ausgabeeinheit 7. Die Ausgabeeinheit 7 kann ein Sprachmodul und/oder eine Bildwiedergabeeinheit sein. Zusätzlich kann die Auswerteeinheit 5 auch mit weiteren Sensoren 8, z. B. Umfeldsensoren und/oder einem GPS-Sensor, vernetzt sein.

Bei der Verwendung zur Unterstützungen Sehbehinderter oder zum Schutz von Individuen in Gefahrumgebung ist der Bildaufnehmer 1 in einem Kleidungsstück integriert. Über das Sprachmodul können natürlich sprachliche Warnhinweise oder Empfehlungen ausgegeben werden, insbesondere auch zusammen mit Navigationshinweisen und/oder Szenenbeschreibungen.

Wenn der erfindungsgemäße Bildaufnehmer 1 an Karosserieteilen formschlüssig angebaut ist oder in diese integriert ist, kann die Auswerteeinheit 5 auch mit einer Navigationseinrichtung, einem Mobiltelefon und/oder einer Car-To-Car-Kommunikationseinrichtung Datentausch führen oder auch Bestandteil einer solchen Einrichtung sein.

Für Überwachungseinrichtungen kann der Bildaufnehmer 1 durch seine Flexibilität oder formstabile Wölbung unauffällig und formschlüssig an Konturen montiert werden, ohne dass sein Vorhandensein ohne Weiteres registriert werden kann.

## Patentansprüche

1. Bildaufnehmer (1) bestehend aus einer Array-Struktur, wobei pro Pixel der Array-Struktur ein Fotosensor (2) mit einer Mikrolinse (3) ausgestattet ist, **dadurch gekennzeichnet, dass** die Array-Struktur formstabil gewölbt ausgebildet ist, zur Anpassung an gewölbte Oberflächen oder permanent flexibel ausgebildet ist.

2. Bildaufnehmer nach Anspruch 1, **dadurch gekennzeichnet, dass** der Bildaufnehmer (1) in ein Kleidungsstück integriert ist.

3. Bildaufnehmer nach Anspruch 1, **dadurch gekennzeichnet, dass** der Bildaufnehmer (1) in Karosserieteile integriert ist oder an ein Karosserieteil formschlüssig angebaut ist.

4. Bildaufnehmer nach einem der Ansprüche 1 bis 3, **dadurch gekennzeichnet, dass** der Bildaufnehmer (1) an eine Auswerteeinrichtung (5) angeschlossen ist.

5. Bildaufnehmer nach Anspruch 4, **dadurch gekennzeichnet, dass** der Bildaufnehmer (1) mit mindestens einem weiteren Sensor (8) zu einem Gesamtsystem zusammengeschaltet ist.

6. Bildaufnehmer nach Anspruch 5, **dadurch gekennzeichnet, dass** der weitere Sensor (8) ein Umfeldsensor oder ein GPS-Sensor ist.

7. Bildaufnehmer nach einem der Ansprüche 1 bis 6, **dadurch gekennzeichnet, dass** der Bildaufnehmer (1) selbst oder über eine ihm zugeordnete Auswerteeinrichtung (5) mit einer Ausgabeeinheit (7), insbesondere einem Sprachmodul und/oder einer Bildwiedergabeeinheit, verbunden ist.

8. Bildaufnehmer nach einem der Ansprüche 1 bis 7, **dadurch gekennzeichnet, dass** der Bildaufnehmer (1) in einem Kommunikationsgerät wie ein Navigationssystem oder ein Mobiltelefon integriert ist oder eingerichtet ist, mit einem solchen Kommunikationsgerät zusammenzuarbeiten.

9. Verwendung des Bildaufnehmers nach einem der Ansprüche 1 bis 8 zur Unterstützung Sehbehinderter oder zum Schutz von Individuen in Gefahrumgebung.

10. Verfahren zur Herstellung eines Bildaufnehmers (1), bestehend aus einer Array-Struktur, wobei pro Pixel der Array-Struktur ein Fotosensor (2) mit einer Mi-krolinse (3) ausgestattet wird, **dadurch gekennzeichnet, dass** die Array-Struktur formstabil gewölbt wird, zur Anpassung an gewölbte Oberflächen oder dass die mit Mikrolinsen (3) ausgestatteten Fotosensoren (2) auf einer permanent flexiblen Folie (6) aufgetragen werden oder in diese integriert werden.

11. Verfahren nach Anspruch 10, **dadurch gekennzeichnet, dass** die formstabil gewölbte Array-Struktur an Karosserieteile formschlüssig angebaut wird oder in diese integriert wird.

12. Verfahren nach Anspruch 10, **dadurch gekennzeichnet, dass** die permanent flexible Folie in einem Kleidungsstück integriert wird.
